(19) Europäisches Patentamt
European Patent Office
Office européen des brevets

(11) EP 2 098 803 A1

(12) **EUROPEAN PATENT APPLICATION**
published in accordance with Art. 153(4) EPC

(43) Date of publication:
**09.09.2009 Bulletin 2009/37**

(21) Application number: **07850407.3**

(22) Date of filing: **11.12.2007**

(51) Int Cl.:
**F24J 2/00** (2006.01)   **H01L 31/04** (2006.01)
**H01M 14/00** (2006.01)

(86) International application number:
**PCT/JP2007/073841**

(87) International publication number:
**WO 2008/075584 (26.06.2008 Gazette 2008/26)**

(84) Designated Contracting States:
**AT BE BG CH CY CZ DE DK EE ES FI FR GB GR
HU IE IS IT LI LT LU LV MC MT NL PL PT RO SE
SI SK TR**

(30) Priority: **20.12.2006 JP 2006343025**

(71) Applicant: **Electric Power Development Co., Ltd.
Chuo-ku, Tokyo 1048165 (JP)**

(72) Inventors:
• **HIWATASHI, Kenichi**
  **Chigasaki-shi**
  **Kanagawa 253-0041 (JP)**
• **MASUYAMA, Naoto**
  **Chigasaki-shi**
  **Kanagawa 253-0041 (JP)**

(74) Representative: **Pisani, Diana Jean et al
Venner Shipley LLP
20 Little Britain
London EC1A 7DH (GB)**

(54)   **PHOTOVOLTAIC GENERATION HEAT COLLECTING UNIT**

(57)   Provided is a photovoltaic power generation and solar heat collector which can be installed in a small area and can simultaneously maintain a high collection efficiency and a high photoelectric conversion efficiency.

The photovoltaic power generation and solar heat collector (10) includes a dye-sensitized photovoltaic cell (11); and a heat collection panel (12) provided on top of the dye-sensitized photovoltaic cell (11). Sunlight is incident on a top surface of the heat collection panel (12).

## FIG. 2

**Description**

TECHNICAL FIELD

The present invention relates to a photovoltaic power generation and solar heat collector that collects heat from sunlight and performs photoelectric conversion from sunlight.
Priority is claimed on Japanese Patent Application No. 2006-343025 filed on December 20, 2006, the contents of which are incorporated herein by reference.

BACKGROUND ART OF THE INVENTION

These days, it has been widespread practice to install a photovoltaic cell or a heat collection panel (solar water heater and the like) on a roof or the like of a building for effective use of sunlight, to thereby reduce gas and electricity consumption. A heat collection panel, which utilizes heat from sunlight, is completely different in construction from a photovoltaic cell, which utilizes sunlight as electric power by photoelectric conversion. Therefore, for such utilization of sunlight, it has been conventionally required to selectively install either one or to install both of them side by side.
However, a roof or the like that is well exposed to sunlight is limited in area. Therefore, as things stand, few buildings have a roof or the like wide enough to allow installation of the heat collection panel and the photovoltaic cell side by side. On the other hand, it is desired that both of heat and light of sunlight be effectively utilized in terms of maintaining the global environment.
To address such a problem, there is known a photovoltaic power generation and solar heat collector with a hybrid construction of a silicon photovoltaic cell and a heat collection panel to enable effective utilization of both light energy and heat energy from sunlight. For example, Patent Document 1 describes a hybrid photovoltaic power generation and solar heat collector in which a heat collection panel is installed on a rear surface of a silicon photovoltaic cell, the silicon photovoltaic cell being cooled by a heat medium, and the heat from sunlight being recovered through heat exchange between the heat from sunlight and the heat medium. Then, the heat medium is circulated via a heat collection pipe.
The hybrid photovoltaic power generation and solar heat collector described in Patent Document 1 has a construction in which the heat collection pipe is laid in the rear surface of the silicon photovoltaic cell, the heat of the photovoltaic cell being exchanged with the heat of the heat medium circulating in the heat collection pipe. Thereby, the photovoltaic cell is cooled to increase the photoelectric conversion efficiency, and also heat energy from sunlight is removed via the heat medium. Furthermore, the document also describes a construction in which the heat medium is circulated also through a top surface of the photovoltaic cell in a light-transmissive manner, to thereby remove heat energy from sunlight.

PATENT DOCUMENT 1: Japanese Unexamined Patent application, First Publication No. S56-6447

DETAILED DESCRIPTION OF THE INVENTION

PROBLEMS TO BE SOLVED BY THE INVENTION

However, in a silicon photovoltaic cell, its surface is rich in luster, and hence has a high reflectance of light. Therefore, it has a disadvantage of a poor property of absorbing heat and a poor property of absorbing light on the long wavelength side of sunlight. That is, the silicon photovoltaic cell itself has low absorption capacity for the infrared ray (heat ray) region. This has posed a problem in that the amount of heat in the infrared ray region is not allowed to be transferred to the heat medium arranged through the rear surface of the silicon photovoltaic cell, leading to an extremely poor efficiency with which heat energy from sunlight is removed from the heat medium.
The present invention was achieved in view of the above circumstances, and has an object to provide a photovoltaic power generation and solar heat collector capable of keeping a high level of both heat collection efficiency and photoelectric conversion efficiency, and installable in a small area.

MEANS FOR SOLVING THE PROBLEM

As a result of intensive research for solving the above problem, the present invention has found that by use of a dye-sensitized photovoltaic cell that absorbs solar rays up to the long wavelength region, it is possible to improve the heat absorbing capacity of the photovoltaic cell, and to improve the heat collection property as a hybrid panel.
That is, a photovoltaic power generation and solar heat collector of the present invention includes: a dye-sensitized photovoltaic cell that creates electric power from sunlight through photoelectric conversion; and a heat collection panel that heats a heat medium with heat energy from sunlight. The heat collection panel is arranged on the top or bottom of the dye-sensitized photovoltaic cell.

It is preferable that the heat medium exchange heat with the dye-sensitized photovoltaic cell. In the photovoltaic power generation and solar heat collector, it is preferable that the photovoltaic power generation and solar heat collector be maintained at temperatures of no more than 60°C through heat exchange with the heat medium, and that the heat medium further exchange heat with a secondary heat medium in an exterior of the photovoltaic power generation and solar heat collector.

It is preferable that either one of the dye-sensitized photovoltaic cell and the heat collection panel transmit sunlight in a wavelength region that the other of the two mainly absorbs. It is preferable that photoelectric conversion be performed with the heat collection panel mainly absorbing an infrared region of sunlight incident on the photovoltaic power generation and solar heat collector, and the dye-sensitized photovoltaic cell mainly absorbing regions of sunlight other than the infrared region. A porous electrode film forming an anode of the dye-sensitized photovoltaic cell preferably has a thickness of no less than 5 microns, more preferably 5 to 30 microns.

ADVANTAGEOUS EFFECTS OF THE INVENTION

According to the present invention, the heat medium flowing through the heat collection panel is heated by rays in the infrared region (heat rays) included in sunlight, and electric power is generated by the photoelectric conversion in the dye-sensitized photovoltaic cell mainly by means of rays in the ultraviolet region. As a result, it is possible to effectively utilize sunlight over a wide range of wavelengths, and to remove heat and electric power.

Furthermore, with the formation of the heat collection panel on top or bottom of the dye-sensitized photovoltaic cell, the heat medium flowing through the heat collection panel is allowed to absorb the heat of the dye-sensitized photovoltaic cell, to thereby make it possible to cool the dye-sensitized photovoltaic cell. The dye-sensitized photovoltaic cell suffers from deterioration and evaporation of the electrolytic solution, a decrease in generation efficiency, and the like at elevated temperatures. However, with the formation of the heat collection panel in contact with the dye-sensitized photovoltaic cell, it is possible to prevent such an increase in temperature of the electrolytic solution, to thereby maintain the generation efficiency favorable while preventing deterioration of the dye-sensitized photovoltaic cell.

Furthermore, with the formation of the heat collection panel on top or bottom of the dye-sensitized photovoltaic cell, the installation area occupies only half or less of the case where the dye-sensitized photovoltaic cell and the heat collection panel are separately installed side by side. This allows efficient utilization of a roof of a building or the like which is limited in area, to thereby efficiently obtain heat and electric power from sunlight.

BRIEF DESCRIPTION OF THE DRAWINGS

FIG. 1 is a perspective view showing a photovoltaic power generation and solar heat collector (hybrid panel) of the present invention.

FIG. 2 is a cross-sectional view of FIG. 1 taken along the line A-A.

FIG. 3 is a cross-sectional view showing a hybrid panel according to another embodiment of the present invention.

FIG. 4 is a cross-sectional view showing a hybrid panel according to another embodiment of the present invention.

FIG. 5 is a perspective view showing an exemplary construction of a heat collection panel.

FIG. 6 is a perspective view showing an exemplary construction of a heat collection panel.

FIG. 7 is a cross-sectional view showing a hybrid panel according to another embodiment of the present invention.

FIG. 8 is a cross-sectional view showing a hybrid panel according to another embodiment of the present invention.

FIG. 9 is a plan view showing a hybrid panel according to another embodiment of the present invention.

FIG. 10 is a cross-sectional view showing a hybrid panel according to another embodiment of the present invention.

FIG. 11 is a cross-sectional view showing a hybrid panel according to another embodiment of the present invention.

FIG. 12 is an exploded perspective view showing the main part of a hybrid panel according to another embodiment of the present invention.

FIG. 13 is a schematic diagram showing an exemplary installation of a hybrid panel according to the present invention.

FIG. 14 is a cross-sectional view showing an exemplary construction of a heat collection panel.

FIG. 15 is a perspective view showing a hybrid panel according to another embodiment of the present invention.

FIG. 16 is a perspective view showing a hybrid panel according to another embodiment of the present invention.

FIG. 17 is a perspective view showing a hybrid panel according to another embodiment of the present invention.

DESCRIPTION OF THE REFERENCE SYMBOLS

10    PHOTOVOLTAIC POWER GENERATION AND SOLAR HEAT COLLECTOR (HYBRID PANEL)
11    DYE-SENSITIZED PHOTOVOLTAIC CELL
12    HEAT COLLECTION PANEL
15    HEAT MEDIUM

BEST MODE FOR CARRYING OUT THE INVENTION

Hereunder is a description of a photovoltaic power generation and solar heat collector according to an embodiment of the present invention, based on the drawings. Note that the present invention is not limited to such an embodiment. Furthermore, in the drawings used in the following description, main parts may be shown in an enlarged manner for the sake of convenience to make the characteristics of the present invention easier to understand. Therefore, the dimensional ratios among the constituent elements are not necessarily the same as those in actuality.

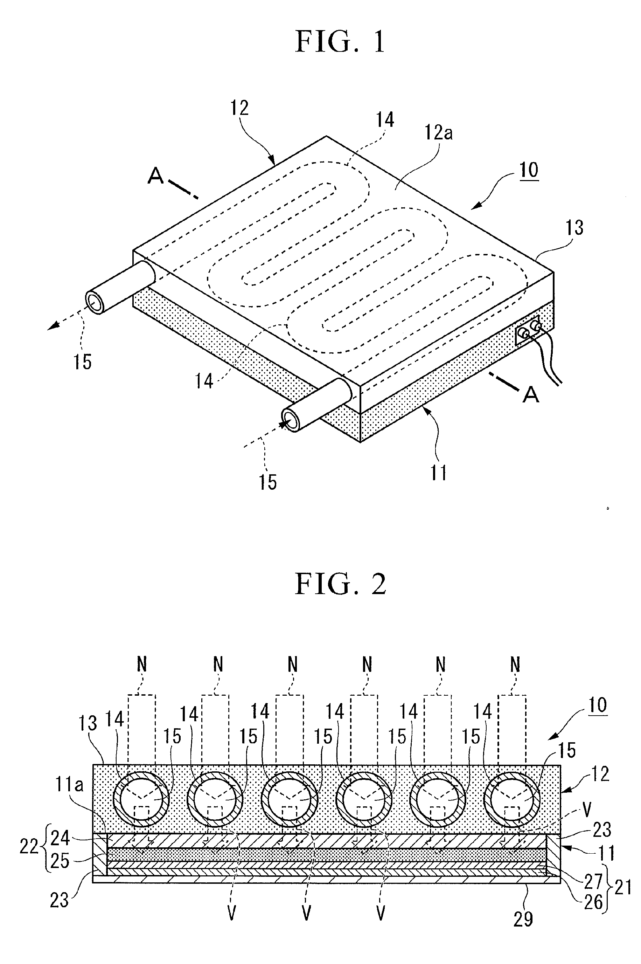

FIG. 1 is a perspective view schematically showing a basic construction of a photovoltaic power generation and solar heat collector of the present invention. FIG. 2 is a cross-sectional view of the photovoltaic power generation and solar heat collector of FIG. 1 taken along the line A-A. A photovoltaic power generation and solar heat collector (hereinafter referred to as hybrid panel) 10 of the present invention includes a dye-sensitized photovoltaic cell 11; and a heat collection panel 12 provided on top of the dye-sensitized photovoltaic cell 11. In the hybrid panel 10, sunlight is incident on a top surface 12a of the heat collection panel 12.

(Heat collection panel)

The heat collection panel 12 has a transparent or colored medium pipe 14 laid, for example, in a snaking manner, in a light-transmissive transparent frame body 13. Through the medium pipe 14, a heat medium 15 is flowed. Thereby, heat is exchanged between the infrared rays (heat rays) included in sunlight and the heat of the dye-sensitized photovoltaic cell 11.

As the medium pipe 14, for example, a thermoplastic resin may be used. For example, it is permissible that the medium pipe 14 be formed from an ABS resin, PP (polypropylene), PE (polyethylene), PS (polystyrene), PMMA (acrylic), PET (polyethylene terephthalate), PPE (polyphenylene ether), PA (nylon/polyamide), PC (polycarbonate), POM (polyacetal), PBT (polybutylene terephthalate), PPS (polyphenylene sulfide), PHEK (polyether ether ketone), a fluoroplastic, a urethane resin, a polychlorinated vinyl resin, or the like. The medium pipe 14 may, for example, have a color that efficiently absorbs the infrared rays (heat rays) included in sunlight, be colored in black, or be transparent so as to allow sunlight to efficiently reach the dye-sensitized photovoltaic cell 11 arranged as an under layer. If the medium pipe 14 is colored, it may be configured such that portions of the medium pipe 14 adjacent to each other are spaced wider so as to allow sunlight to irradiate onto the dye-sensitized photovoltaic cell 11 through between the portions of the medium pipe 14.

In later-described photoelectric conversion of the dye-sensitized photovoltaic cell 11, the dye-sensitized photovoltaic cell 11 utilizes the rays in the ultraviolet region from the incident sunlight. Therefore, if the heat medium 15 for the medium pipe 14 is flowed above an acceptance surface of the dye-sensitized photovoltaic cell 11, it is preferable that a material with a low absorbance of ultraviolet rays be used for the heat medium 15.

Examples of preferable material for the heat medium 15 include: water, low molecular weight alcohol with a carbon number of 1 to 6 such as ethanol, methanol, propanol, glycerin, ethylene glycol, propylene glycol, dipropylene glycol; low molecular weight ether with a carbon number of 1 to 4 such as dimethyl ether, methyl ethyl ether, diethyl ether; and alternatives for chlorofluorocarbon. For absorbing the infrared rays included in sunlight and cooling the dye-sensitized photovoltaic cell 11, the heat medium 15 is not particularly limited to a liquid. The heat may be absorbed through a temperature change in a liquid. However, the heat may be absorbed based on a phase change by use of a liquid with a low boiling point, and then the heat may be recovered from a liquid or a gas used as the heat medium 15 in a separate heat exchange device provided externally.

When the hybrid panel 10 is installed outdoors, it is possible to add an inorganic salt or an organic salt to the heat medium to prevent freezing of the heat medium 15 in cold regions. Furthermore, if a metal pipe is used somewhere in the system through which the heat medium 15 circulates, it is preferable that, for example, a saturated fatty acid or an unsaturated fatty acid be used as an organic material with a rust resistant effect. Examples of a saturated fatty acid preferably include a caprylic acid, a caproic acid, a decanoic acid, a lauric acid, a myristic acid, a palmitic acid, and a stearic acid. Furthermore, examples of unsaturated fatty acid preferably include an oleic acid, a linoleic acid, and a linolenic acid. In addition, as glucose or polysaccharide glucan with glucose as a constitutional unit, oligosaccharide or polysaccharide is also preferably used. Examples thereof include cellulose or dextrose. On the other hand, examples of additives made of an inorganic material with a rust effect include hydrazine, phosphate such as calcium phosphate and magnesium phosphate, and the like.

If the hybrid panel 10 has a construction with the dye-sensitized photovoltaic cell 11 arranged on a bottom surface side of the heat collection panel 12, it is desirable that a material with an ultraviolet absorbance of 10 percent or lower be used for the heat medium 15 in order for the rays in the ultraviolet region included in sunlight to sufficiently reach the dye-sensitized photovoltaic cell 11.

(Dye-sensitized photovoltaic cell)

The dye-sensitized photovoltaic cell 11 has a cathode 21 and an anode 22 opposed to each other whose side edge portions are sealed with a sealing material 23. The anode 22 is one in which porous layer 25 is formed on one surface of a support substrate 24. Furthermore, the cathode 21 is one in which an electrode layer 27 is formed on one surface of a support substrate 26. Then, a dye is adsorbed onto the porous layer 25, and an electrolytic solution is filled between the cathode 21 and the anode 22 that are opposed to each other.

In the dye-sensitized photovoltaic cell 11, it is preferable that the heat collection panel 12 absorb as heat the rays in the wavelength regions that do not contribute to the photoelectric conversion, for example in the infrared region. Therefore, it is preferable that a dye to be adsorbed onto the porous layer 25 of the dye-sensitized photovoltaic cell 11 have a wide range of absorption spectrum, and also suppress the reflected light and transmitted light from the dye-sensitized photovoltaic cell 11.

To suppress the transmitted light on the back surface of the dye-sensitized photovoltaic cell 11, there may be formed a reflector plate 29 such as a metal plate on the back surface of the dye-sensitized photovoltaic cell 11. Alternatively, a metal substrate may be used as the support substrate 25 that forms the cathode 21 of the dye-sensitized photovoltaic cell 11, to thereby reduce the transmission in the entire wavelength regions.

Furthermore, to reduce the reflected light from the dye-sensitized photovoltaic cell 11, it is preferable that if the heat medium 15 is in direct contact with the acceptance surface 11a of the dye-sensitized photovoltaic cell 11, the difference in refraction index between the heat medium 15 and the support substrate 24 of the acceptance surface 11a be nullified, to thereby suppress the reflection on the boundary portion. If the heat medium 15 is in indirect contact with the acceptance surface 11a via a flow passage formation substance, it is preferable that the difference in refraction index between the flow passage formation substance and the support substrate 24 of the acceptance surface 11a be nullified, to thereby suppress the reflection on the boundary portion.

Furthermore, to prevent returning light from inside the dye-sensitized photovoltaic cell 11, it is preferable that a metal oxide layer for dye adsorption of the porous layer 25 constituting the anode 22 of the dye-sensitized photovoltaic cell 11 be made thicker, or that a dye absorbing a wider range of wavelengths be used in the metal oxide layer to improve the light absorption property. Examples of dye preferably include a black dye, N3, or the like. In addition, if a carbon-based material which carries Pt is used as the electrode layer 27 of the cathode 21, it is possible to improve the property of absorbing light in the long wavelength range of the dye-sensitized photovoltaic cell 11. To enhance the light absorption capacity of the dye-sensitized photovoltaic cell 11 and enhance the property as a heat absorber body, the porous layer 25 of the anode 22 preferably has a thickness of no less than 1 $\mu$m, more preferably no less than 5 $\mu$m.

With the construction of the dye-sensitized photovoltaic cell 11 as described above, it is preferable that the reflectance of light from the acceptance portion 11a of the dye-sensitized photovoltaic cell 11 be no more than 10% of the incident light (sunlight) at wavelengths from 200 nm to 800 nm. Furthermore, it is preferable that the light absorbance of the dye-sensitized photovoltaic cell 11 be no less than 30% of the incident light at wavelengths from 800 nm to 1200 nm.

As the support substrate 24 constituting the anode 22 of the dye-sensitized photovoltaic cell 11, one with high transparency can be preferably used. For example, as a substrate made from a glass-based material, a soda-lime glass, a silica substrate, or a lead glass can be used. Alternatively, a plastic substrate can be used which is made from a plastic-based material such as polycarbonate, an acrylate resin, a polyvinylidene chloride resin, a styrol resin, an AS resin, a methacrylic resin, polyethylene terephthalate, tetraacetyl cellulose, polyphenyl sulfide, polyarylate, polyetherimide, or a phenoxy resin.

On such a support substrate 24, fluorine-doped tin oxide (FTO), zinc oxide with oxygen vacancies, an ITO or the like is deposited by the screen printing method, the spray method, the sputtering method, the MOCVD method, or the like to fabricate a substrate with a sheet resistance of no more than 100 $\Omega$, preferably no more than 30 $\Omega$. It is preferably that the thickness of the deposition be no less than 0.1 $\mu$m.

It is permissible that the porous layer 25 formed on the support substrate 24 be made of a semiconductor of, for example, a metal oxide. As a formation method of the porous layer 25, a printing method may be used such as a doctor blade method, a die coater method, screen printing, spray printing, gravure printing, and a spin coating method. It is required to vary the viscosity of slurry or paste to be used, according to the printing methods. To fabricate the slurry or paste, titanium oxide powder with the rutile crystal structure is added to titanium oxide powder with the anatase crystal structure, and is mixed using an alcohol, water, or the like as a solvent, the viscosity being controlled by an amount of the solvent so as to be in the range of 1 to 1000 cPa·s. At this time, the titanium oxide powder with the anatase crystal structure may be further mixed with a metal oxide such as silicon oxide or zinc oxide. As the case may be, the added powder may include a binder resin based on cellulose, polyvinyl alcohol, or the like, the content of which is approximately 1 to 10% by weight of the added powder.

The film applied on the support substrate 24 is deposited so as to have a thickness of no less than 1 $\mu$m, preferably approximately 5 to 30 $\mu$m after drying. After that, in the case where the support substrate 24 is a soda-lime glass substrate, it is fired at temperatures of 350 to 550°C to form a porous layer 25 that includes titanium oxide. In the case where the support substrate 24 is a plastic film, an alkoxide of titanium, for example titanium (IV) ethoxide (Ti $(C_2H_5O)_4$) may be dissolved in ethanol. Then the solution may be sprayed onto the film and be dried at approximately 100°C to form a porous layer 25 made from titanium oxide.

Furthermore, a sol solution fabricated by adding water to an alcohol solution which is a dilute solution of an alcoxide of titanium can be used. The sol solution may be applied on the film by the spray method and be dried at approximately 100°C to form a porous layer 25. Furthermore, organometallic titanium may be previously mixed into a paste or slurry. The paste or slurry then may be applied on the film by the screen printing method or the spray method, and be dried at approximately 100°C to form a porous layer 25.

Particles of titanium oxide powder used for the porous layer 25 have the anatase crystal structure with a diameter of 5 to 400 nm, preferably a diameter of 10 to 100 nm. This titanium oxide powder may include titanium oxide powder with the rutile crystal structure. Alternatively, one in which titanium oxide with the rutile crystal structure or another crystal phase is partly included in titanium oxide with the anatase crystal structure may be used.

In the porous layer 25, oxide powder such as of zinc oxide, magnesium oxide, silicon oxide, and aluminum oxide with a particle size of 0.2 to 5 $\mu$m may be mixed for functioning as a diffusing component for the transmitted light, to thereby make it possible to improve the photoelectric efficiency. Furthermore, on the porous layer 25 that includes titanium oxide, there may be laminated, as a diffusing component for the transmitted light, zinc oxide, magnesium oxide, silicon oxide, aluminum oxide, or the like in a powered form with a particle size of 0.2 to 5 $\mu$m.

A void volume of the porous layer 25 is found by measuring its thickness with a stylus film thickness meter. It is preferable that the porous layer 25 have a void ratio of 20 to 80 percent, the void ratio being measured from a weight change between when the porous layer is impregnated with water at 20°C and when it has been dried.

Furthermore, it is required to adsorb a dye on the porous layer 25. Before and after the adsorption of the dye, an alcoxide based on for example ketone, carboxylic acid, ether, or the like, a metal alcoxide, a metal complex, a metal salt, or the like is used to form a high-resistance film or an adsorption layer with a thickness of no more than 5 nm on the titanium oxide for the reverse electron movement. Thereby, it is possible to improve the photoelectric efficiency.

In the case where a resin substrate with a low heat resistance, for example a film based on PC, PE, PVC, or Teflon (registered trademark) is used as the support substrate 24, a conducting film is formed on for example a PC substrate by a deposition method such as the sputtering method, the vapor deposition method, or the CVD method. At this time, if a pinhole occurs in the conducting film deposited on the resin substrate, a solvent of the electrolytic solution swells or solves the resin substrate, resulting in exfoliation of the conducting film. Therefore, it is preferable that the film be deposited in a clean room.

Furthermore, of the formation methods of a conducting film, the sputtering method is typically favorable in terms of control and mass production. It is desirable that a film be deposited in a chamber by continuous sputtering. As a deposition material for a conducting film, ITO is easy to control because it is unlikely to be influenced by the deposition environment. However, also in the case of zinc oxide or tin oxide as a material of a conducting film, it is easy to perform doping for the n type and the p type. Therefore, the material is not particularly limited to an ITO.

With such a deposition process, conductivity is imparted to the film used as a conducting film so that the sheet resistance of the film is no more than 100 $\Omega$. Then, an alcoxide or metal salt of titanium, or a sol solution of titanium mixed with titanium oxide powder with the anatase crystal structure is applied on this transparent conducting film. The film is then dried at approximately 100°C to form the porous layer 25 made of a porous metal oxide. The temperature at this time is not limited to 100°C. The drying is performed at no more than a high service temperature limit of the film material. At this time, a metal alcoxide or a titanium sol solution is mixed with titanium oxide powder with the anatase crystal structure. The mixture is spread on the film by the screen printing method or the spray method, and is immobilized through a gelation reaction at room temperature to at approximately 50°C. Thereby, it is possible to reduce the exfoliation of the porous layer 25 due to thermal expansion of the support substrate 24 and to reduce a thermal damage to the support substrate 24.

In the case where a film based on PC, PE, PVC, or Teflon (registered trademark) is used to fabricate the dye-sensitized photovoltaic cell 11, a transparent conducting film is formed as a foundation of the porous layer 25. Furthermore, the deposition of aluminum oxide, silicon oxide, or the like in order to facilitate a formation of a dense film as the foundation on the surface of the film or to increase barrier capacity against oxygen or water is also advantageous in improvement of durability. This deposition is similarly applicable to the cathode 21, the opposite electrode. For example, a barrier film

EP 2 098 803 A1

against oxygen or water is formed on a PC film. Then, a transparent conducting film is formed thereon. Furthermore, Pt with a thickness of no less than 10 nm is deposited thereon by the sputtering method or the like to form the electrode layer 27, which is used in the cathode 21.

Examples of dye to be adsorbed on the porous layer 25 made of titanium oxide include a dye based on ruthenium bipyridine, a dye based on azo, a dye based on quinone, a dye based on quinonimine, a dye based on quinacridone, a dye based on squarylium, a dye based on cyanine, a dye based on merocyanine, a dye based on triphenylmethane, a dye based on xanthene, a dye based on porphyrin, a dye based on phthalocyanine, a dye based on perylene, a dye base on indigo, a dye based on naphthalocyanine, a dye based on coumarin.

As a method of adsorbing a dye on the porous layer 25 made of titanium oxide, for example a method of immersing the porous layer 25 formed on the support substrate 24 into a solution in which a dye is dissolved (solution for adsorbing a dye) can be used. As a solvent for dissolving a dye, one that dissolves a dye is permissible. To be more specific, examples of solvent include alcohols such as ethanol, ketones such as acetone, ethers such as diethyl ether and tetrahydrofuran, nitrogen compounds such as acetonitrile, halogenated aliphatic hydrocarbons such as chloroform, aliphatic hydrocarbons such as hexane, aromatic hydrocarbons such as benzene, and esters such as ethyl acetate.

Two or more types of these solvents may be mixed for use. It is possible to appropriately adjust the concentration of the dye in the solution according to the types of the dye and solvent to be used. It is preferable that the concentration be as high as possible for enhancing the adsorption function. However, at a high concentration, a layer with excessive adsorption is formed on the surface of the titanium oxide constituting the porous layer 25. Therefore, it is permissible that the concentration be preferably no less than $3 \times 10^{-4}$ mols/liter.

As a redox pair of the electrolytic solution filled between the cathode 21 and the anode 22, a redox electrolyte or the like such as an $I_3^-/I^-$-based electrolyte or s $Br_3^-/Br^-$-based electrolyte can be used. An $I_3^-/I^-$-based electrolyte in which an oxidant constituting a redox pair is $I_3^-$ and a reductant constituting the redox pair is $I^-$ is preferably used. Examples thereof include a combination of $I_2$ width an iodide such as a metal iodide such as LiI, NaI, KI, CsI, and CaI$_2$; and an iodine salt of a quaternary ammonium compound such as tetraalkylammonium iodide, pyridinium iodide, imidazolium iodide. In the case where an electrolyte made of an iodine-based redox solution is used, it is preferable that the cathode be made of platinum or a conductive carbon material and that the catalyst particles be made of platinum or a conductive carbon material.

Examples of solvent of the electrolyte include: a carbonate compound such as ethylene carbonate and propylene carbonate; a heterocyclic compound such as 3-methyl-2-oxazolidinone; an ether compound such as dioxane and diethyl ether; ethers such as ethylene glycol dialkyl ether, propylene glycol dialkyl ether, polyethylene glycol dialkyl ether, polypropylene glycol dialkyl ether, ethylene glycol monoalkyl ether, propylene glycol monoalkyl ether, polyethylene glycol monoalkyl ether, and polypropylene glycol monoalkyl ether; alcohols such as methanol and ethanol; polyhydric alcohols such as ethylene glycol, polypropylene glycol, polyethylene glycol, polypropylene glycol, and glycerin; a nitrile compound such as acetonitrile, glutarodinitrile, methoxy acetonitrile, propionitrile, and benzonitrile; and an aprotic substance such as dimethyl sulfoxide and sulfolane.

The concentration of the electrolyte may be appropriately set according to the type of the electrolyte and the solvent. For example, the concentration is 0.01 to 1.5 mols/liter, preferably 0.01 to 0.7 mols/liter. As a specific example of an electrolyte, one in which lithium iodide, iodine, and tertial butylpyridine are dissolved in acetonitrile so that the lithium iodide has a concentration of 0.06 mols/liter, the iodine has a concentration of 0.06 mols/liter, and the tertial butylpyridine has a concentration of 0.3 mols/liter.

As a method of joining the support substrate 26 constituting the cathode 21 to the support substrate 24 constituting the anode 22 by means of the sealing material 23, for example the support substrate 24 on which the porous layer 25 made of a dye-adsorbed titanium oxide is formed is opposed to the support substrate 26 provided with the electrode layer 27 in which the transparent conducting film carries platinum. Then, an ionomer resin, for example an organic material such as HIMILAN (trade name), is used to thermally fusion-bond the support substrate 24 to the support substrate 26 for sealing fixation. Furthermore, their circumferential outer portion is sealed with a material with gas barrier capacity. A similar advantage is obtained by the attachment of packing made of a butyl rubber, a fluoroplastic, a silicon resin, or the like to the joint portion of the sealing material 23, the packing being pressurized for fixation.

According to the photovoltaic power generation and solar heat collector (hybrid panel) 10 with a construction described in detail as above, the heat medium 15 flowing through the heat collection panel 12 is heated by rays in the infrared region (heat rays) included in sunlight N, and electric power is generated by the photoelectric conversion in the dye-sensitized photovoltaic cell 11 mainly by means of rays V in the ultraviolet region. As a result, it is possible to effectively utilize sunlight over a wide range of wavelengths, and to remove heat and electric power.

Furthermore, with the formation of the heat collection panel 12 on top of the dye-sensitized photovoltaic cell 11, the heat medium 15 flowing through the heat collection panel 12 is allowed to absorb the heat of the dye-sensitized photovoltaic cell 11, to thereby make it possible to cool the dye-sensitized photovoltaic cell 11 to a temperature of, for example, no more than 60°C. The dye-sensitized photovoltaic cell 11 suffers from deterioration and evaporation of the electrolytic solution, a decrease in generation efficiency, and the like at elevated temperatures. However, with the formation of the heat collection panel 12 in contact with the dye-sensitized photovoltaic cell 11, it is possible to prevent such an increase in temperature of the electrolytic solution, to thereby maintain the generation efficiency favorable while preventing deterioration of the dye-sensitized photovoltaic cell 11.

Furthermore, with the formation of the heat collection panel 12 on top of the dye-sensitized photovoltaic cell 11, the installation area occupies only half or less of the case where the dye-sensitized photovoltaic cell and the heat collection panel are separately installed side by side. This allows efficient utilization of a roof and the like limited in area of a building, to thereby efficiently obtain heat and electric power from sunlight.

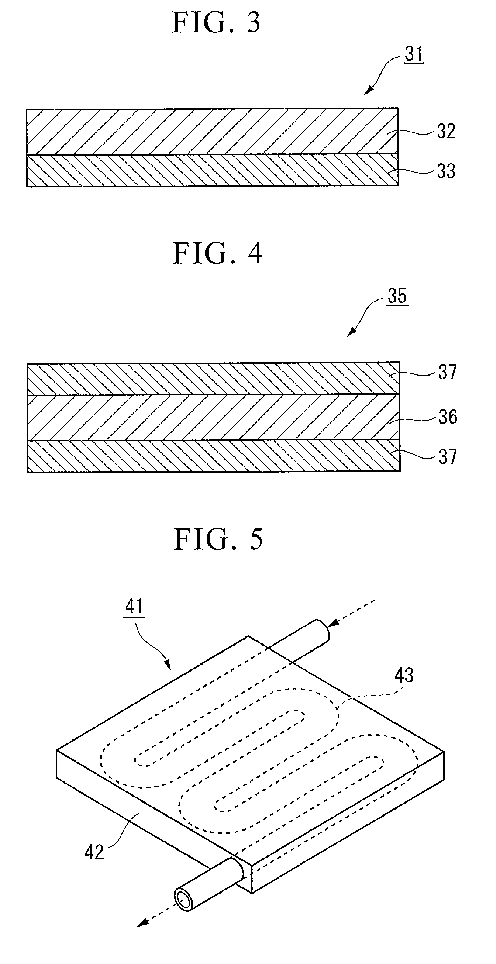

Hereunder, an illustration of a variety of embodiments of the photovoltaic power generation and solar heat collector (hybrid panel) according to the present invention is described. As is the case with a hybrid panel 31 shown in FIG. 3, a dye-sensitized photovoltaic cell 32 may be installed on top of a heat collection panel 33. Then, while the dye-sensitized photovoltaic cell 32 is cooled from its backside with the heat collection panel 33, the heat collection panel 33 may be heated with the infrared rays having transmitted the dye-sensitized photovoltaic cell 32. Furthermore, as is the case with a hybrid panel 35 shown in FIG. 4, heat collection panels 37 may be installed so as to sandwich the dye-sensitized photovoltaic cell 36 from top and bottom, to thereby further enhance the cooling capacity of the dye-sensitized photovoltaic cell 36 and to remove heat more efficiently.

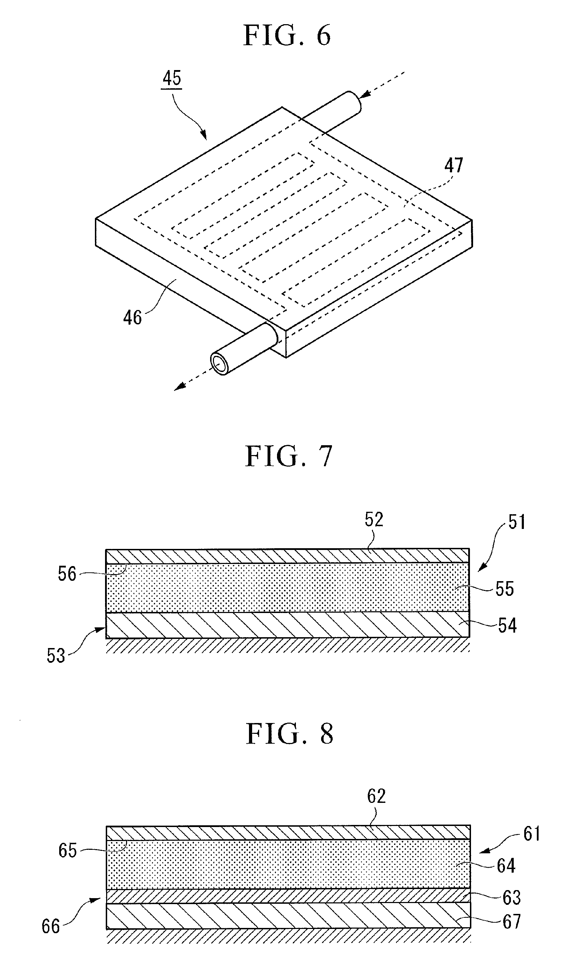

As an exemplary construction of the heat collection panel, a medium pipe 43 may be laid in a snaking manner along a plane of a frame body 42 of a heat collection panel 41 from one side surface thereof to the other, as shown in FIG. 5. Alternatively, as shown in FIG. 6, a medium pipe 47 may be laid in a multiple-branched manner along a plane of a frame body 46 of a heat collection panel 45 so that when the heat collection panel 45 is arranged in an inclined manner, the heat medium generally flows from up to down or from down to up.

Other than these, as a construction of the heat collection panel, the heat medium may be flowed in a manner in direct contact with the support substrate of the dye-sensitized photovoltaic cell that is provided on the top or bottom of the heat collection panel, without independently providing the medium pipe for flowing the heat medium and the like in the frame body of the heat collection panel. For example, as shown in FIG. 7, a flow passage (medium pipe) 56 of a heat medium 55 may be formed between an upper plate 52 constituting a frame body of a heat collection panel 51 and a support substrate 54 constituting an electrode of a dye-sensitized photovoltaic cell 53. Furthermore, as shown in FIG. 8, a flow passage (medium pipe) 65 of a heat medium 64 may be formed between an upper plate 62 and a lower plate 63 which constitute a frame body of a heat collection panel 61, and a support substrate 67 of a dye-sensitized photovoltaic cell 66 may be in contact with the lower plate 63.

The heat medium flowing inside the heat collection panel may be directly utilized, that is, cold water may be flowed as a heat medium, which is utilized as it is as warm water after the heat exchange. Furthermore, indirect utilization may be adopted in which the heat medium flowing inside the heat collection panel is flowed as a primary heat medium through a closed-system flow passage, and then the heat absorbed into the primary heat medium is exchanged with the heat of a secondary heat medium in a separate heat exchange device provided externally. Examples of the secondary heat medium include water stored in a heat storage tank. At this time, instead of releasing the heat to the secondary heat medium such as water from the primary heat medium via the heat exchange device, a circulation pipe may be laid in the floor, a wall, or the like of a building, through which the primary heat medium is flowed to warm the floor or wall. To recover heat, two methods are available: natural recovery and forced recovery using a pump. The present invention is not limited to either one.

As a strength which is required in the hybrid panel, the support substrate forming an acceptance surface of the dye-sensitized photovoltaic cell is required to be strong against wind and rain, and also be resistant to hail, in light resistance and light transmittance, in the case where with the acceptance surface of the dye-sensitized photovoltaic cell as the topmost surface, the heat collection panel is installed on the back surface side of the dye-sensitized photovoltaic cell.

Examples of material for such a support substrate include an undyed glass with strength such as a soda-lime glass. Furthermore, examples of plastic-based material for a support substrate include a polycarbonate or acrylate resin, a polyvinylidene chloride resin, a styrol resin, an AS resin, a methacrylic resin, polyethylene terephthalate, tetraacetyl cellulose, polyphenylene sulfide, polyarylate, polyetherimide, a phenoxy resin. It is possible to provide the surface of the plastic substrate with a hard coat layer or the like, to thereby make the plastic substrate further scratch-proof. It is preferable that the topmost portion of the heat collection panel be made from the similar material as that described above, even in the case where the heat collection panel is installed on top of the dye-sensitized photovoltaic cell.

In terms of the property of absorbing far-infrared rays, a glass substrate has a high absorbance. Therefore, if a glass substrate is installed, as a support substrate of the dye-sensitized photovoltaic cell, on the topmost surface on the acceptance portion side of the hybrid panel, there is apprehension that a loss occurs due to radiant heat on the glass substrate on the topmost surface or due to thermal diffusion on the glass substrate on the topmost surface to air. Consequently, in the case where a glass substrate is used, it is preferable that a surface of the glass be coated with a material with low thermal conductivity. Furthermore, it is desirable that a resin-based substrate be used for the support substrate on the topmost surface, to thereby reduce the absorption of rays in the infrared region.

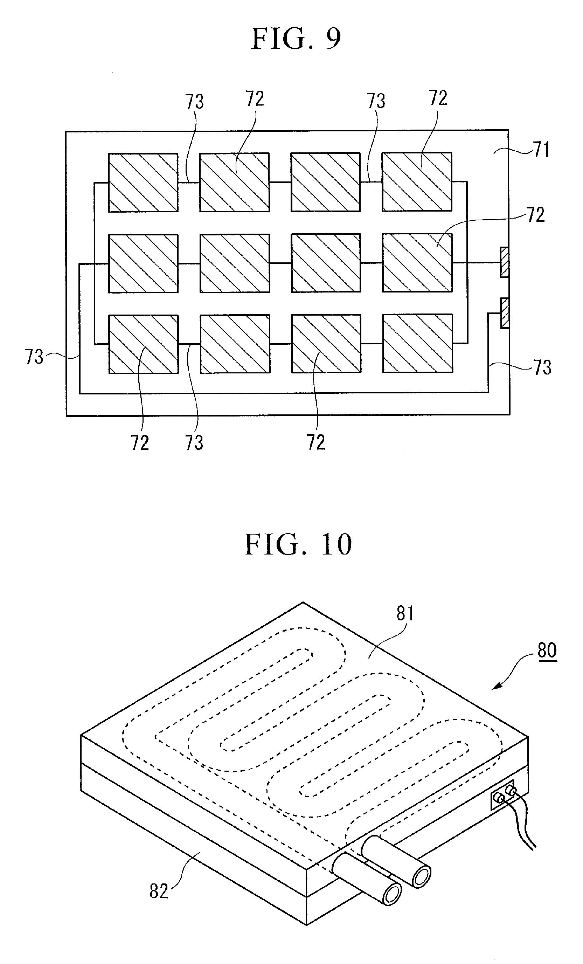

A dye-sensitized photovoltaic cell for use in a hybrid panel may be made of a large-scale dye-sensitized photovoltaic cell formed in one enclosure, and a heat collection panel may be provided thereon. However, as shown in FIG. 9, a multitude of small dye-sensitized photovoltaic cells 72 may be arranged in a single enclosure 71, and the dye-sensitized photovoltaic cells 72 may be connected by lead wires 73. At this time, the dye-sensitized photovoltaic cells 72 may be connected in series parallel, and the setting may be made so as to obtain targeted voltage and current value.

Electric power that is output from the dye-sensitized photovoltaic cell constituting the hybrid panel may be output to an inverter or the like for use as a stabilized power supply. Alternatively it may be configured such that electric power is stored in a capacitor or a secondary battery, or stored as hydrogen energy produced by splitting water, and that the power is removed as required.

Hereunder is a further enumeration of exemplary constructions of the photovoltaic power generation and solar heat collector (hybrid panel) according to the present invention. A hybrid panel 80 shown in FIG. 10 is integrally formed of a dye-sensitized photovoltaic cell 82 and a heat collection panel 81 provided on top of the dye-sensitized photovoltaic cell 82. It is configured such that if the dye-sensitized photovoltaic cell 82 has its temperature increased through warming by sunlight, the temperature of the dye-sensitized photovoltaic cell 82 is prevented from reaching an elevated temperature by a heat medium circulating through the heat collection panel 81. With this integral formation of the heat collection panel 81 with the dye-sensitized photovoltaic cell 82, the construction work when the hybrid panel is installed on a roof or the like of a building is easy. It is preferable that such integration of the heat collection panel 81 with the dye-sensitized photovoltaic cell 82 be previously performed in a manufacturing plant.

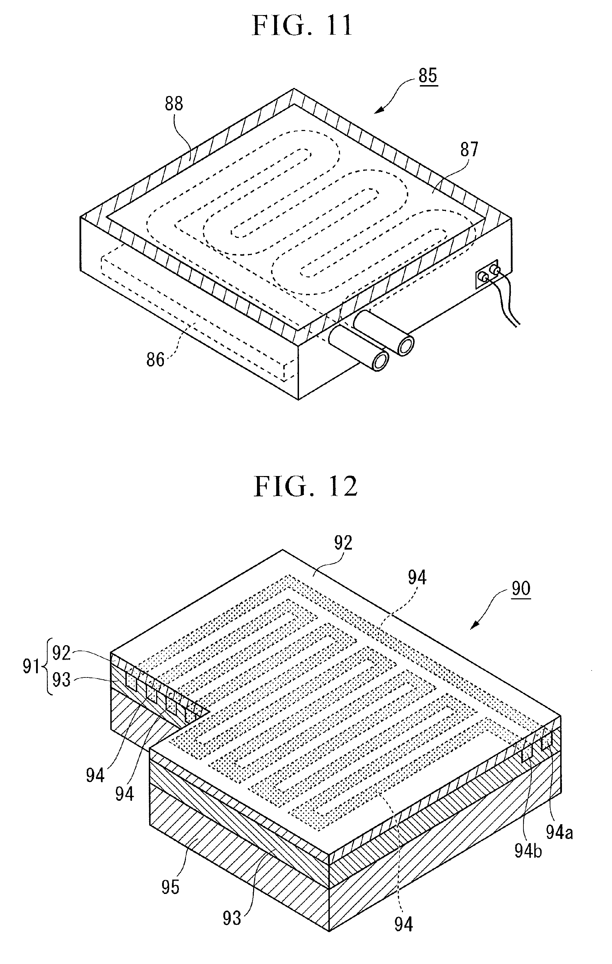

Furthermore, in a hybrid panel 85 shown in FIG. 11, for example when laid on a roof of a general building, jigs for fixing the hybrid panel 85 are formed on the roof. After that, a dye-sensitized photovoltaic cell 86 is mounted thereon. Then, a heat collection panel 87 is installed on top thereof. In this installation condition, a frame body 88 made of a metal such as SUS or aluminum is provided around peripheral end portions of the integrated entity to reinforce peripheral edges. Thereby, it is possible to actualize the hybrid panel 85 excellent in durability and easy to install.

In a hybrid panel 90 shown in FIG. 12, a heat collection panel 91 is made of a plate-like heat collector in which an upper plate 92 and a lower plate 93 is joined. In the upper plate 92 and/or the lower plate 93, a snaking (meandering) groove 94 for flowing a heat medium is formed, thus functioning as a flow passage of the heat medium. The upper plate 92 and the lower plate 93 are formed from, for example, a transparent reinforced plastic or the like. For example, a snaking groove with both ends opened may be previously provided in a top surface of the lower plate 93. Then, the upper plate 92 for covering upper surface of the groove may be overlaid thereon. Subsequently, both may be integrated at contact locations by adhesion or welding. An inlet end 94a and an outlet end 94b of the flow passage for the heat medium in this case are provided in the same edge surface on a short edge side of the heat collection panel 91. They are connectable to the pipes for circulating the heat medium via joints.

To assemble the hybrid panel 90 shown in FIG. 12, the heat collection panel 91 is installed on top of a dye-sensitized photovoltaic cell 95. At this time, the heat collection panel 91 and the dye-sensitized photovoltaic cell 95 are brought into close contact with each other so as to prevent formation of a space therebetween. Subsequently, peripheral edge portions may be sealed with a shock-absorbing sealing material such as a soft polyurethane foam. Then, finally, this may be fitted and attached into the edges (peripheral edge portions) of the panel that is assembled from latitudinal and longitudinal frame portions.

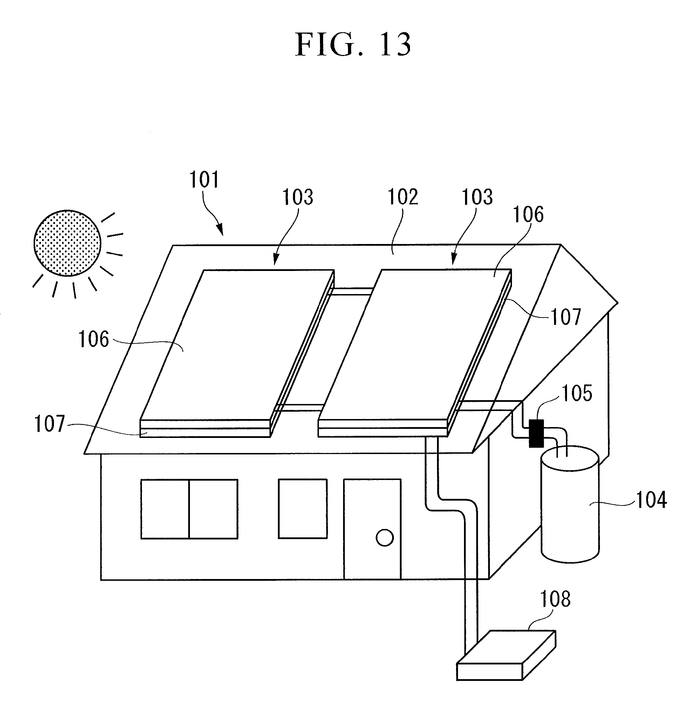

FIG. 13 is a conceptual diagram where a hybrid panel is installed on a house. Hybrid panels 103 are installed on a roof 102 of a house 101. On the ground, a hot water storage tank 104, a pump 105 for circulating a heat medium, and the like are installed. The hot water storage tank 104 exchanges heat with the heat medium that is warmed by heat collection panels 106 constituting the hybrid panels 103. Thereby, the hot water storage tank 104 warms stored cold water into warm water and supplies it to a hot water supply facility or a floor heating facility using hot water in the house. On the other hand, the electric power obtained by dye-sensitized photovoltaic cells 107 constituting the hybrid panels 103 is supplied to the interior of the house via an inverter 108 or the like.

EXAMPLES

Hereunder, a description of more specific exemplary constructions of the photovoltaic power generation and solar heat collector (hybrid panel) and verification results of the advantages according to the present invention are provided.

(Verification 1)

In the dye-sensitized photovoltaic cell constituting the hybrid panel, 10-cm-square glass plates with a thickness of 3 mm were used as support substrates, the glass plates having been cut out from a soda-lime glass plate (manufactured by Nippon Sheet Glass Co., Ltd.) on which was formed a transparent conducting film. In one of the glass substrates, a titanium oxide paste (SOLARONIX, trade name: Nanoxide HT) was applied with a thickness of 20 $\mu$m by the screen printing method on the surface where the transparent conducting film was formed. The applied film was fired at 450°C for one hour. Furthermore, on this, a titanium oxide paste (SOLARONIX, trade name: Nanoxide D) was applied with a thickness of 20 $\mu$m. The applied film was fired at 450°C for one hour. An aluminum was deposited with a thickness of 1 $\mu$m by the vapor deposition method on a rear surface, which was without a transparent conducting film, of the other glass substrate for a cathode, and the backside surface was mirror polished.

Subsequently, the glass substrate on which the titanium oxide electrode film was formed was immersed in an ethanol solution in which ruthenium-complex-based dye Ruthenium 535 (SOLARONIX, trade name: Ruthenium 535) had a concentration of $5 \times 10^{-4}$ mols/liter, and was held for eight hours. Then, the glass substrate was immersed heat collection panel in a dehydrated ethanol to remove excess dye, and was dried at 100°C. When the electrode film was formed, the printing was performed so as to prevent the titanium oxide paste from being attached onto a margin of 3 mm from a peripheral edge portion of the glass plate. On the peripheral edge portion of the glass plate, there was attached HIMILAN (Spacer S manufactured by DU PONT-MITSUI POLYCHEMICALS CO., LTD. (trade name: HIMILAN) hereinafter, the same applies) with a thickness of 60 $\mu$m, with a width of 3 mm from outside to inside.

In one of the glass substrates forming opposite electrodes, on which the transparent conducting film was formed, Pt with a thickness of 200 nm was deposited on the transparent conducting film by the sputtering method. Two holes with a diameter of 1 mm were bored with a drill at both ends in the diagonal line direction on one-on-one basis. A load of 10 gf/cm$^2$ was applied across these two glass substrates. In this state, the glass substrates were thermally fusion-bonded at 120°C using HIMILAN (trade name). An acetonitrile electrolytic solution, in which LiI and I$^2$ were dissolved, was injected into the fabricated cell at the filler holes. The solution was injected so as to be uniformly filled in the entire dye-sensitized photovoltaic cell to fabricate the dye-sensitized photovoltaic cell.

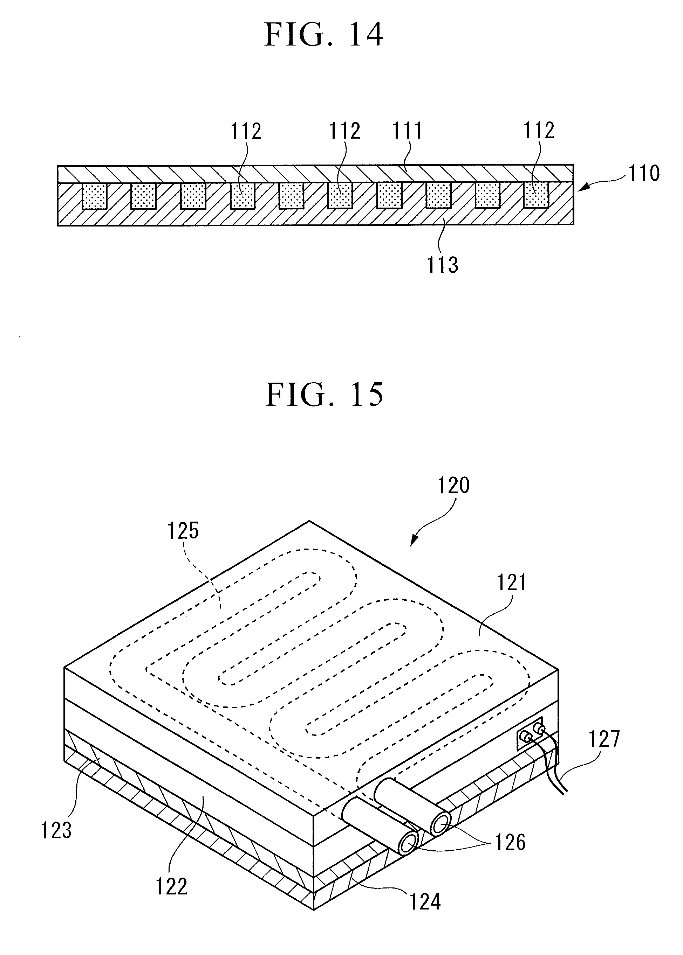

On the other hand, in the heat collection panel constituting the hybrid panel, a 2-mm-thick, 10-cm-square acrylate resin plate with a high ultraviolet ray transmittance was used as an upper plate 111, as shown in FIG. 14. To this, a lower plate 113 made of a 2-mm-thick acrylate resin plate was adhered in which a flow passage 112 was formed for a heat medium. For the adhesion, an instant adhesive was used. At inlet/outlet ports of the flow passage 112 formed in the lower plate 113, there were formed joints for circulation of a cooling medium, to fabricate a heat collection panel 110.

A fabricated heat collection panel 121 was installed on the acceptance portion side of a dye-sensitized photovoltaic cell 122, with an epoxy-resin-based adhesive applied on the adhesion surfaces. These two were sealed so as not to allow leakage of a cooling medium to fabricate a hybrid panel 120. On the rear side of the hybrid panel 120, that is, on the back surface of the dye-sensitized photovoltaic cell 122, there was adhered a 1-cm-thick porous urethane foam 123 for providing heat retaining capacity. Furthermore, on top of this, there was attached a polyethylene film 124 with an adhesive. In addition, a medium pipe 125 is laid in the heat collection panel 121 in a snaking manner. Heat medium inlet/outlet ports 126 were provided in a side edge portion of the heat collection panel. On a side edge portion of the dye-sensitized photovoltaic cell 122, there were connected electric power output lines 127. An outline of the whole of the hybrid panel 120 fabricated in this manner is shown in FIG. 15. This hybrid panel was used as Example 1.

As a conventional example for the hybrid panel of the present invention as described above, a hybrid panel was manufactured with a similar construction, with the difference being that a polycrystalline silicon photovoltaic cell was used instead of the dye-sensitized photovoltaic cell. This hybrid panel was used as Comparative example 1. Characteristics between the two were compared, with the portions that accept light being shielded so as to have the same 10-cm-square area. As a cooling medium that was flowed through the heat collection panel, an ethylene glycol solution was used. With its amount fixed to 20 cc, the heat medium was circulated with a micropump at a flow rate of 5 cc/min. For the circulation, a 50-cc sampling bottle with a lid was used in a bored portion in the foam polystyrene. A temperature sensor was put in the sampling bottle. The sampling bottle was connected to the input/output ports of the heat medium of the heat collection panel via the micropump by use of a silicone tube, and the heat medium was circulated. Then, the photoelectric conversion efficiency and the increase in temperature of the heat medium were measured.

For the measurement, the photocurrent density in short circuit (Jsc), the open-circuit photo voltage (Voc), the fill factor (F.F.), and the power conversion efficiency ($\eta$ (%)) of the dye-sensitized photovoltaic cells in the hybrid panels of Example 1 and Comparative Example 1 were measured. Note that the power conversion efficiency ($\eta$ (%)) of the dye-sensitized photovoltaic cell is expressed by the following formula (A), where P0 represents the incident light intensity [mWcm$^{-2}$], Voc represents the open-circuit photo voltage [V], Jsc represents the photocurrent density in short circuit [mA·cm$^{-2}$], and F.F. represents the fill factor.

$$\eta = 100 \times (Voc \times Jsc \times F.F.)/P0 \cdots \text{formula (A)}$$

The cell characteristic evaluation test was performed under a measurement condition in which an irradiation condition of simulated solar light from a xenon light source through an AM filter (AM 1.5) by use of a solar simulator (Yamashita Denso Corporation, trade name: YS-100H) is 100mW/cm$^2$ (so-called "1 sun" illumination). The results of the photoelectric conversion efficiency are shown in Table 1. Furthermore, the results of the measurement of change in liquid temperature of the heat medium after five hours are shown in FIG. 2.

Table 1

|  | Voc V | Jsc mA/cm$^2$ | F.F. | η % |
|---|---|---|---|---|
| Example 1 | 0.677 | 12.23 | 0.52 | 4.31 |
| Comparative Ex 1 | 0.489 | 18.50 | 0.66 | 5.97 |

Table 2

|  | Temperature °C |
|---|---|
| Example 1 | 44 |
| Comparative Example 1 | 35 |

These results show that the photoelectric conversion efficiency of Example 1 using the dye-sensitized photovoltaic cell is a little smaller than that of Comparative Example 1 using the silicon photovoltaic cell. On the other hand, Example 1 has a greater amount of increase in liquid temperature, and hence, is better than Comparative Example 1 using the silicon photovoltaic cell. Therefore, it has been found that if used as a hybrid panel, Example 1 with the construction where the heat collection panel is arranged on top of the dye-sensitized photovoltaic cell offers a more improved heat collection characteristic.

(Verification 2)

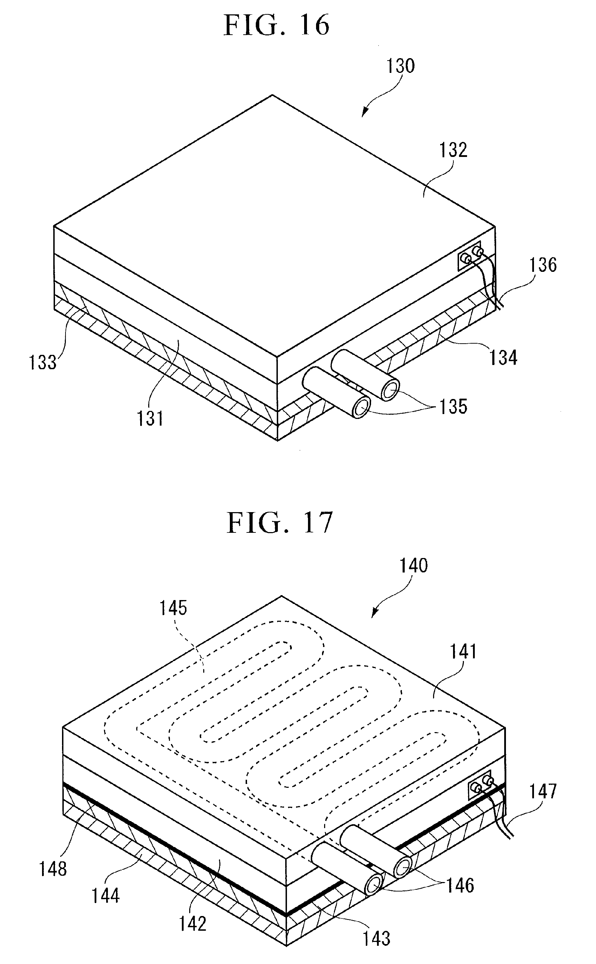

Next, a construction in which the order of accumulating the dye-sensitized photovoltaic cell and the heat collection panel of Example 1 was reversed, that is the dye-sensitized photovoltaic cell was provided on top of the heat collection panel was used as Example 2. The construction is shown in FIG. 16. A dye-sensitized photovoltaic cell 132 was installed on a fabricated heat collection panel 131, with an epoxy-resin-based adhesive applied on the adhesion surfaces. These two were sealed so as not to allow leakage of a cooling medium to fabricate a hybrid panel 130. On the rear side of the hybrid panel 130 (i.e., on the back surface of the fabricated heat collection panel 131), a 1-cm-thick porous urethane foam 133 was adhered for providing heat retaining capacity. Furthermore, on top of this, a polyethylene film 134 with an adhesive was attached. In addition, heat medium inlet/outlet ports 135 were provided in a side edge portion of the heat collection panel 131. On a side edge portion of the dye-sensitized photovoltaic cell 132, there were connected electric power output lines 136. A hybrid panel was manufactured with a similar construction, with the difference being that a polycrystalline silicon photovoltaic cell was used instead of the dye-sensitized photovoltaic cell of Example 2. This hybrid panel was used as Comparative example 2. The photoelectric conversion efficiency and the increase in temperature of the heat medium of Example 2 and Comparative Example 2 were measured. The measurement condition was the same as that of the aforementioned Example 1. The results of the photoelectric conversion efficiency in Example 2 and Comparative Example 2 are shown in Table 3. Furthermore, the results of the measurement of change in liquid temperature of the heat medium after five hours are shown in FIG. 4.

Table 3

|  | Voc V | Jsc mA/cm$^2$ | F.F. | η % |
|---|---|---|---|---|
| Example 2 | 0.707 | 10.23 | 0.52 | 4.85 |
| Comparative Ex 2 | 0.492 | 20.40 | 0.66 | 6.62 |

Table 4

|  | Temperature °C |
|---|---|
| Example 2 | 42 |
| Comparative Example 2 | 34 |

These results show that the photoelectric conversion efficiency of Example 2 using the dye-sensitized photovoltaic cell is a little smaller than that of Comparative Example 2 using the silicon photovoltaic cell. On the other hand, Example 2 has a greater amount of increase in liquid temperature, and hence is better than Comparative Example 2 using the silicon photovoltaic cell. Therefore, it has been found that if used as a hybrid panel, Example 2 with the construction where the dye-sensitized photovoltaic cell is arranged on top of the heat collection panel offers a more improved heat collection characteristic.

(Verification 3)

In Example 1, an epoxy-based adhesive including 10% by weight of carbon was applied with a thickness of approximately 10 $\mu$m on the surface of the lower plate of the heat collection panel, and was cured. At this time, the Pt-carrying glass substrate that functions as the cathode of the dye-sensitized photovoltaic cell was not subjected to an aluminum vapor deposition. It was configured such that transmitted light was absorbed by the heat collection panel. The heat collection panel was installed on the back surface of the dye-sensitized photovoltaic cell. This was used as Example 3. A hybrid panel was manufactured with a similar construction, with the difference being that a polycrystalline silicon photovoltaic cell was used instead of the dye-sensitized photovoltaic cell of Example 3. This hybrid panel was used as Comparative example 3. The photoelectric conversion efficiency and the increase in temperature of the heat medium of Example 3 and Comparative Example 3 were measured. The measurement condition was the same as that of the aforementioned Example 1. The results of the photoelectric conversion efficiency in Example 3 and Comparative Example 3 are shown in Table 5. Furthermore, the results of the measurement of change in liquid temperature of the heat medium after five hours are shown in FIG. 6.
Table 5

|  | Voc V | Jsc mA/cm$^2$ | F.F. | $\eta$ % |
|---|---|---|---|---|
| Example 3 | 0.707 | 10.23 | 0.52 | 4.86 |
| Comparative Ex 3 | 0.492 | 20.40 | 0.66 | 6.62 |

Table 6

|  | Temperature °C |
|---|---|
| Example 3 | 43 |
| Comparative Example 3 | 35 |

These results show that the photoelectric conversion efficiency of Example 3 using the dye-sensitized photovoltaic cell was a little smaller than that of Comparative Example 3 using the silicon photovoltaic cell. On the other hand, Example 3 has a greater amount of increase in liquid temperature, and hence is better than Comparative Example 3 using the silicon photovoltaic cell. Furthermore, it has been found that with a formation of a light absorbing film on a heat collection panel installed on the back surface of the dye-sensitized photovoltaic cell, heat collectivity was improved.

(Verification 4)

In the dye-sensitized photovoltaic cells constituting the hybrid panels, 10-cm-square glass plates with a thickness of 3 mm were used as support substrates, the glass plates having been cut out from soda-lime glass plates (manufactured by Nippon Sheet Glass Co., Ltd.) on which was formed a transparent conducting film. In six glass substrates of these, a titanium oxide paste (SOLARONIX, trade name: Nanoxide HT) was applied with a thickness of 5 $\mu$m by the screen

printing method on the surfaces where the transparent conducting films were formed. The applied films were fired at 450°C for one hour. Furthermore, on these, a titanium oxide paste (SOLARONIX, trade name: Nanoxide D) was appropriately applied. At this time, for the glass substrates, the thicknesses of the paste were varied stepwise as 1.2 $\mu$m, 3.2 $\mu$m, 5.4 $\mu$m, 8.2 $\mu$m, 15.3 $\mu$m, and 19.5 $\mu$m. These glass substrates were used as Examples 4 to 9. Then, a heat collection effect was checked while the absorbance of light was varied according to the thickness of the electrode film for dye adsorption.

The films on which the titanium oxide paste (SOLARONIX, trade name: Nanoxide D) was applied were fired at 450°C for one hour. Powder in which equal amounts of silicon oxide with an average particle size of 200 nm and a gel of silicon oxide were mixed was made into a paste form. The paste was applied on the films with a thickness of 10 $\mu$m. Then, the glass substrates were fired at 450°C for one hour. Subsequently, the glass substrates were immersed in an ethanol solution in which an organic dye (CHEMICREA Inc., trade name: D120) had a concentration of $5 \times 10^{-4}$ mols/liter, and were held for eight hours. Then, the glass substrates were immersed in a dehydrated ethanol to remove excess dye, and were dried at 100°C. When the electrode films were formed, the printing was performed so as to prevent the titanium oxide paste from being attached onto a margin of 3 mm from peripheral edge portions of the glass plates. On the peripheral edge portions of the glass plates, there was attached HIMILAN (Spacer S manufactured by DU PONT-MITSUI POLYCHEMICALS CO., LTD. (trade name: HIMILAN)) with a thickness of 60 $\mu$m, with a width of 3 mm from outside to inside.

In opposing glass substrates forming opposite electrodes, on which was formed the transparent conducting film, Pt with a thickness of 50 nm was deposited on the transparent conducting film by the sputtering method. Four holes with a diameter of 1 mm were bored with a drill at each corner. A load of 10 gf/cm$^2$ was applied across the paired glass substrates. In this state, the glass substrates were thermally fusion-bonded at 120°C using HIMILAN (trade name). An acetonitrile electrolytic solution, in which LiI and I$_2$ were dissolved, was injected into the fabricated cell at the filler holes. The solution was injected so as to be uniformly filled in the entire dye-sensitized photovoltaic cell to fabricate the dye-sensitized photovoltaic cell.

On the other hand, in the heat collection panel constituting the hybrid panel, a 2-mm-thick, 10-cm-square acrylate resin plate with a high ultraviolet ray transmittance was used as an upper plate 111, as shown in FIG. 14. To this, a lower plate 113 made of a 2-mm-thick acrylate resin plate was adhered in which a flow passage 112 is formed for a heat medium. For the adhesion, an instant adhesive was used. At inlet/outlet ports of the flow passage 112 formed in the lower plate 113, there were formed joints for circulation of a cooling medium, to fabricate a heat collection panel 110.

A fabricated heat collection panel 141 was installed on the acceptance portion side of a dye-sensitized photovoltaic cell 142, with an epoxy-resin-based adhesive applied on the adhesion surfaces. These two were sealed so as not to allow leakage of a cooling medium to fabricate a hybrid panel 140. On the rear side of the fabricated hybrid panel 140, that is, on the backside of the dye-sensitized photovoltaic cell 142, there was adhered a 1-cm-thick porous urethane foam 143 for providing heat retaining capacity. Furthermore, on top of this, there was attached a polyethylene film 144 with an adhesive. In addition, a medium pipe 145 is laid in the heat collection panel 141 in a snaking manner. Heat medium inlet/outlet ports 146 were provided in a side edge portion of the heat collection panel. On a side edge portion of the dye-sensitized photovoltaic cell 142, there were connected electric power output lines 147. Not that an aluminum foil 148 may not be deposited on the back surface of the dye-sensitized photovoltaic cell. An outline of the whole of the hybrid panel 140 fabricated in this manner is shown in FIG. 17.

As a cooling medium that was flowed through the heat collection panel, an ethylene glycol solution was used. With its amount fixed to 20 cc, the heat medium was circulated with a micropump at a flow rate of 5 cc/min. For the circulation, a 50-cc sampling bottle with a lid was used in a bored portion in the foam polystyrene. A temperature sensor was put in the sampling bottle. The sampling bottle was connected to the input/output ports of the heat medium of the heat collection panel via the micropump by use of a silicone tube, and the heat medium was circulated. Then, the photoelectric conversion efficiency and the increase in temperature of the heat medium were measured.

The cell characteristic evaluation test was performed under simulated solar light from a xenon light source through an AM filter (AM 1.5) by use of a solar simulator (Yamashita Denso Corporation, trade name: YS-100H) is 100mW/cm$^2$ (so-called "1 sun" illumination). The results of the photoelectric conversion efficiency in Examples 4 to 9 in which the thicknesses of the titanium oxide films were varied stepwise are shown in Table 7. Furthermore, the results of the measurement of change in liquid temperature of the heat medium after five hours are shown in FIG. 8.

Table 7

|  | Film Thickness $\mu$m | Voc V | Jsc mA/cm$^2$ | F.F. | $\eta$ % |
|---|---|---|---|---|---|
| Example 4 | 1.2 | 0.732 | 3.5 | 0.52 | 1.33 |
| Example 5 | 3.2 | 0.725 | 5.4 | 0.53 | 2.07 |

(continued)

|  | Film Thickness $\mu$m | Voc V | Jsc mA/cm$^2$ | F.F. | $\eta$ % |
|---|---|---|---|---|---|
| Example 6 | 5.4 | 0.728 | 7.9 | 0.52 | 2.99 |
| Example 7 | 8.2 | 0.715 | 8.8 | 0.52 | 3.27 |
| Example 8 | 15.3 | 0.698 | 10.2 | 0.51 | 3.63 |
| Example 9 | 19.5 | 0.688 | 10.6 | 0.50 | 3.65 |

Table 8

|  | Film Thickness $\mu$m | Light absorbance % | Temperature °C |
|---|---|---|---|
| Example 4 | 1.2 | 12 | 28 |
| Example 5 | 3.2 | 35 | 33 |
| Example 6 | 5.4 | 58 | 37 |
| Example 7 | 8.2 | 72 | 39 |
| Example 8 | 15.3 | 93 | 44 |
| Example 9 | 19.5 | 100 | 45 |

These results show that the photoelectric conversion efficiency of the dye-sensitized photovoltaic cell is improved by varying the film thickness of the light-absorbing porous electrode film, and also that the thicker the film is, the more the light absorbance is improved and the heat collection effect is also improved.

INDUSTRIAL APPLICABILITY

According to the photovoltaic power generation and solar heat collector (hybrid panel) of the present invention, the heat medium flowing through the heat collection panel is heated by rays in the infrared region (heat rays) included in sunlight, and electric power is generated by the photoelectric conversion in the dye-sensitized photovoltaic cell mainly by means of rays in the ultraviolet region. As a result, it is possible to effectively utilize sunlight over a wide range of wavelengths, and to remove heat and electric power. Furthermore, the heat medium flowing through the heat collection panel is allowed to absorb the heat of the dye-sensitized photovoltaic cell, to thereby make it possible to cool the dye-sensitized photovoltaic cell. Therefore, it is possible to maintain the generation efficiency favorable while preventing deterioration of the dye-sensitized photovoltaic cell. In addition, it is possible to efficiently utilize a roof and the like limited in area of a building, to thereby efficiently obtain heat and electric power from sunlight. Therefore, the photovoltaic power generation and solar heat collector (hybrid panel) of the present invention is industrially useful.

**Claims**

1. A photovoltaic power generation and solar heat collector comprising:

   a dye-sensitized photovoltaic cell that takes out electric power from sunlight through photoelectric conversion; and
   a heat collection panel that heats a heat medium with heat energy from sunlight, the heat collection panel being arranged on a top or bottom of the dye-sensitized photovoltaic cell.

2. The photovoltaic power generation and solar heat collector according to claim 1, wherein the heat medium exchanges heat with the dye-sensitized photovoltaic cell.

3. The photovoltaic power generation and solar heat collector according to claim 2, wherein the photovoltaic power generation and solar heat collector is maintained at temperatures of no more than 60°C through heat exchange with the heat medium, and the heat medium further exchanges heat with a secondary heat medium in an exterior of the photovoltaic power generation and solar heat collector.

4. The photovoltaic power generation and solar heat collector according to claim 1, wherein either one of the dye-sensitized photovoltaic cell and the heat collection panel transmits sunlight in a wavelength region that the other of the two mainly absorbs.

5. The photovoltaic power generation and solar heat collector according to claim 4, wherein photoelectric conversion is performed with the heat collection panel mainly absorbing an infrared region of sunlight incident on the photovoltaic power generation and solar heat collector, and the dye-sensitized photovoltaic cell mainly absorbing regions of sunlight other than the infrared region.

6. The photovoltaic power generation and solar heat collector according to claim 1, wherein a porous electrode film forming an anode of the dye-sensitized photovoltaic cell has a thickness of no less than 5 microns.

# FIG. 1

# FIG. 2

# FIG. 3

# FIG. 4

# FIG. 5

## FIG. 6

## FIG. 7

## FIG. 8

# FIG. 9

# FIG. 10

# FIG. 11

# FIG. 12

# FIG. 13

# FIG. 14

# FIG. 15

# FIG. 16

# FIG. 17

## INTERNATIONAL SEARCH REPORT

| International application No. |
|---|
| PCT/JP2007/073841 |

A. CLASSIFICATION OF SUBJECT MATTER
*F24J2/00*(2006.01)i, *H01L31/04*(2006.01)i, *H01M14/00*(2006.01)i

According to International Patent Classification (IPC) or to both national classification and IPC

B. FIELDS SEARCHED

Minimum documentation searched (classification system followed by classification symbols)
F24J2/00, H01L31/04, H01M14/00

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2008 |
| Kokai Jitsuyo Shinan Koho | 1971-2008 | Toroku Jitsuyo Shinan Koho | 1994-2008 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y | JP 2006-317128 A (Masao TOMIOKA), 24 November, 2006 (24.11.06), Full text; Figs. 1 to 6 (Family: none) | 1-6 |
| Y | JP 2525189 B2 (Shimizu Corp.), 14 August, 1996 (14.08.96), Full text; Figs. 1 to 3 (Family: none) | 1-6 |
| Y | JP 2006-176834 A (Nissan Motor Co., Ltd.), 06 July, 2006 (06.07.06), Par. Nos. [0029] to [0036]; Figs. 7, 8 (Family: none) | 1-6 |

| ☒ Further documents are listed in the continuation of Box C. | ☐ See patent family annex. |
|---|---|

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 14 February, 2008 (14.02.08) | 26 February, 2008 (26.02.08) |

| Name and mailing address of the ISA/ | Authorized officer |
|---|---|
| Japanese Patent Office | |
| Facsimile No. | Telephone No. |

Form PCT/ISA/210 (second sheet) (April 2007)

**INTERNATIONAL SEARCH REPORT**

International application No.

PCT/JP2007/073841

| C (Continuation). DOCUMENTS CONSIDERED TO BE RELEVANT | | |
|---|---|---|
| Category* | Citation of document, with indication, where appropriate, of the relevant passages | Relevant to claim No. |
| Y | JP 2006-90659 A (Matsushita Electric Industrial Co., Ltd.), 06 April, 2006 (06.04.06), Par. Nos. [0020] to [0043]; Figs. 1 to 8 (Family: none) | 3 |
| Y | JP 2005-222782 A (Bridgestone Corp.), 18 August, 2005 (18.08.05), Par. Nos. [0034] to [0037]; Fig. 1 (Family: none) | 6 |

Form PCT/ISA/210 (continuation of second sheet) (April 2007)

**EP 2 098 803 A1**

**REFERENCES CITED IN THE DESCRIPTION**

**Patent documents cited in the description**

- JP 2006343025 A
- JP S566447 B